# EUROPEAN PATENT APPLICATION

(11) **EP 2 437 317 A2**
(43) Date of publication of application: **04.04.2012**
(21) Application number: 11181452.1
(22) Date of filing: 15.09.2011
(51) Int. Cl.: H01L 31/18, B23K 26/36, B23K 26/03

(54) **Method and system for scribing a multilayer panel**

(30) Priority: 29.09.2010 US 893288
(71) Applicant: General Electric Company, Schenectady, NY 12345 (US)
(72) Inventor: Zhang, Wenwu, Niskayuna, NY New York 12309 (US); Harding, Kevin George, Niskayuna, NY New York 12309 (US); Jones, Marshall Gordon, Niskayuna, NY New York 12309 (US); Deluca, John Anthony, Niskayuna, NY New York 12309 (US); Frey, Jonathan Mack, Denver, CO 80203 (US)
(74) Representative: Bedford, Grant Richard

(57) **Abstract**

The present invention provides a method of scribing a multilayer panel. The method comprises (a) providing a multilayer panel comprising a substrate layer, a transparent conductive layer disposed thereupon, a first semiconducting layer disposed upon the transparent conductive layer; (b) configuring the multilayer panel relative to a laser machining device, the machining device comprising a laser head and an optical sensor; (c) inducing a motion of the laser head relative to the multilayer panel such that a laser beam contacts the panel along a transverse line across the panel, the laser beam incident upon the panel having sufficient energy to ablate one or more layers of the multilayer panel within a zone irradiated by the laser beam to provide a scribed panel; (d) simultaneously irradiating the scribed panel with a first light source; and (e) detecting the light emerging from the scribed panel at the optical sensor in real time. Also provided is a system for scribing a multilayer panel.

## Description

The invention relates generally to a method and system for scribing a multilayer panel, and more particularly to a method and system for scribing multilayer panels useful in photovoltaic cells and modules employing the same.

One of the main focuses in the field of photovoltaic devices is the improvement of energy conversion efficiency (from electromagnetic energy to electric energy or vice versa). Solar energy is abundant in many parts of the world year around. Unfortunately, the available solar energy is not generally used efficiently to produce electricity. Photovoltaic ("PV") devices convert light directly into electricity. Photovoltaic devices are used in numerous applications, from small energy conversion devices for calculators and watches to large energy conversion devices for households, utilities, and satellites.

Typically, photovoltaic devices having thin film solar cells are manufactured using thin film deposition processes known in the art to build layers of various materials on to a substrate. The efficiency of these thin films in the photovoltaic device depends on how effectively the films are sectioned into specific sizes, their connectivity to conducting materials and isolation from neighboring cells. The sectioning and connecting of the layers are mainly achieved by scribing methods, either using mechanical means or using lasers. Generally, the production of the thin film solar cells is carried out at high speed in high volume production operations, and the scribing process is an important portion of the chain of process steps. The quality and the depth of the scribed line is an essential criterion for the later efficiency of the thin film, and the tolerances for the depth of each the scribed line may be on the order of a few tens of nanometers.

Conventionally, off-line techniques have been used to characterize the depth and quality of the scribed line. Methods known in the art include direct optical observations, precision scribing profile measurement and the electrical performance measurement of the depth of the scribed line. However, the above mentioned off-line methods may be time consuming and cost ineffective. Additionally, the conventional off-line techniques can be used to characterize only a small portion of the scribed line or must resort to batchwide characterization of scribed lines.

Therefore there remains a need for a robust technique to characterize the scribed lines effectively to help control both the long term and short term process capability in addition to being cost effective.

In one aspect, the present invention provides a method of scribing a multilayer panel. The method comprising (a) providing a multilayer panel comprising a substrate layer, a transparent conductive layer disposed thereupon, a first conducting layer disposed upon the transparent conductive layer; (b) configuring the multilayer panel relative to a laser machining device, the machining device comprising a laser head and an optical sensor; (c) inducing a motion of the laser head relative to the multilayer panel such that the laser beam contacts the panel along a transverse line across the panel, the laser beam incident upon the panel having sufficient energy to ablate one or more layers of the multilayer panel within a zone irradiated by the laser beam irradiated to provide a scribed panel; (d) simultaneously irradiating at least a portion of the scribed panel with light from a first light source; and (e) detecting the light emerging from the scribed panel at the optical sensor in real time.

In another aspect, the present invention provides a system for scribing a multilayer panel comprising: a laser machining device; a first light source; and an inferential sensor. The laser machining device comprising a laser source, a laser head and an optical sensor. The optical sensor is configured to receive light emerging from a multilayer panel.

Various features, aspects, and advantages of the present invention will become better understood when the following detailed description is read with reference to the accompanying drawings in which like characters represent like parts throughout the drawings, wherein:
Fig. 1 is a flow chart illustrating the method of scribing a multilayer panel in accordance with an embodiment of the invention.
Fig. 2 is a schematic illustration of a scribed multilayer panel in accordance with an embodiment of the invention.
Fig. 3 is a schematic illustration of a system to scribe a multilayer panel in accordance with an embodiment of the invention.
Fig. 4 is schematic illustration of the light intensity profile over a scribed feature in accordance with an embodiment of the invention.
Fig. 5 is a schematic of gantry configuration of a system to scribe a multilayer panel in accordance with an embodiment of the invention.

In the following specification and the claims, which follow, reference will be made to a number of terms, which shall be defmed to have the following meanings.

The singular forms "a", "an" and "the" include plural referents unless the context clearly dictates otherwise. Approximating language, as used herein throughout the specification and claims, may be applied to modify any quantitative representation that could permissibly vary without resulting in a change in the basic function to which it is related. Accordingly, a value modified by a term such as "about" is not to be limited to the precise value specified. In some instances, the approximating language may correspond to the precision of an instrument for measuring the value. Similarly, "free" may be used in combination with a term, and may include an insubstantial number, or trace amounts, while still being considered free of the modified term.

As used herein, the terms "may" and "may be" indicate a possibility of an occurrence within a set of circumstances; a possession of a specified property, characteristic or function; and/or may qualify another verb by expressing one or more of an ability, capability, or possibility associated with the qualified verb. Accordingly, usage of "may" and "may be" indicates that a modified term is apparently appropriate, capable, or suitable for an indicated capacity, function, or usage, while taking into account that in some circumstances the modified term may sometimes not be appropriate, capable, or suitable. For example, in some circumstances, an event or capacity can be expected, while in other circumstances, the event or capacity cannot occur ― this distinction is captured by the terms "may" and "may be".

"Optional" or "optionally" means that the subsequently described event or circumstance may or may not occur, and that the description includes instances where the event occurs and instances where it does not. The terms "comprising", "including", and having are intended to be inclusive and mean that there may be additional elements other than the listed elements. Furthermore, whenever a particular feature of the invention is said to consist of at least one of a number of elements of a group and combinations thereof, it is understood that the feature may comprise or consist of any of the elements of the group, either individually or in combination with any of the other elements of that group.

It is also understood that terms such as "top," "bottom," "outward," "inward," and the like are words of convenience and are not to be construed as limiting terms. As used herein, the terms "disposed over", or "disposed between" refers to both secured or disposed directly in contact with and indirectly by having intervening layers therebetween.

As noted, in one embodiment the present invention provides method of scribing a multilayer panel, the method comprising: (a) providing a multilayer panel comprising a substrate layer, a transparent conductive layer disposed thereupon, a first semiconducting layer disposed upon the transparent conductive layer; (b) configuring the multilayer panel relative to a laser machining device, the machining device comprising a laser head and an optical sensor; (c) inducing a motion of the laser head relative to the multilayer panel such that the laser beam contacts the panel along a transverse line across the panel, the laser beam incident upon the panel having sufficient energy to ablate one or more layers of the multilayer panel within a zone irradiated by the laser beam to provide a scribed panel; (d) simultaneously irradiating the scribed panel with a first light source ; and (e) detecting the light emerging from the scribed panel at the optical sensor in real time.

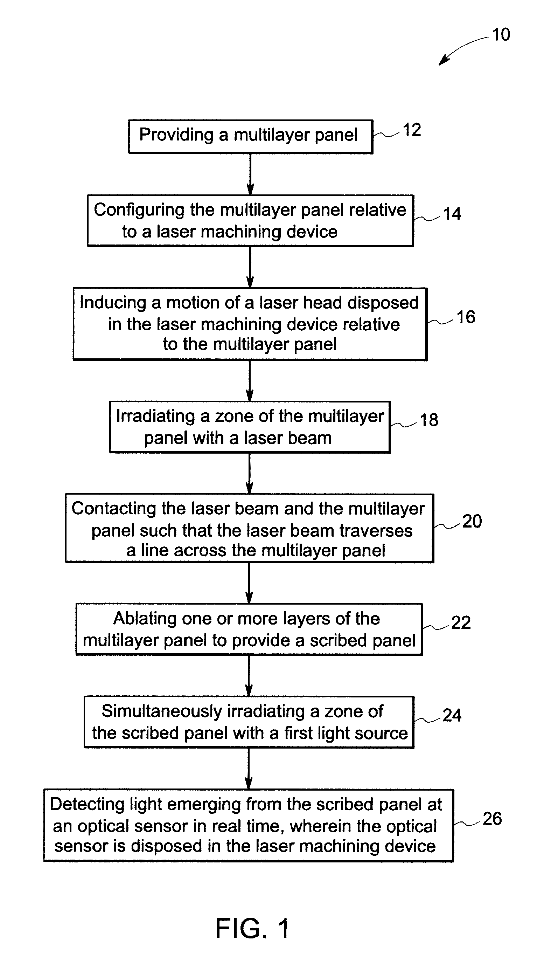

Referring to Fig. 1, the figure shows a flow chart 10 illustrating a method scribing a multilayer panel in accordance with an embodiment of the present invention. In a first method step 12, a multilayer panel is provided. The multilayer panel may be any known multilayer panel known to one skilled in the art. In one embodiment, the multilayer panel is a component of a photovoltaic device. In a second method step 14 the multilayer panel is configured relative to a laser machining device. The laser machining device includes a laser head and an optical sensor. In the method step 16 an inducing motion of the laser head is made relative to the multilayer panel. In the fourth method step 18, a zone of the multilayer panel is irradiated with a laser beam from a laser source. In one embodiment, the laser machining device includes a laser source. In the method step 20 the laser beam is contacted with the multilayer panel such that the laser beam traverses a line across the multilayer panel. Following the method step 20, in step 22 the laser beam ablates one or more layers of the multilayer panel to provide a scribed panel. Following method steps 20-24, the scribed panel is simultaneously irradiated with light from a first light source. In method step 26, the light emerging from the scribed panel is detected at the optical sensor in the laser machining device in real time. In an alternate embodiment, in step 26, the light emerging from the multilayer panel both from the scribed region and the non-scribed region is detected in real time.

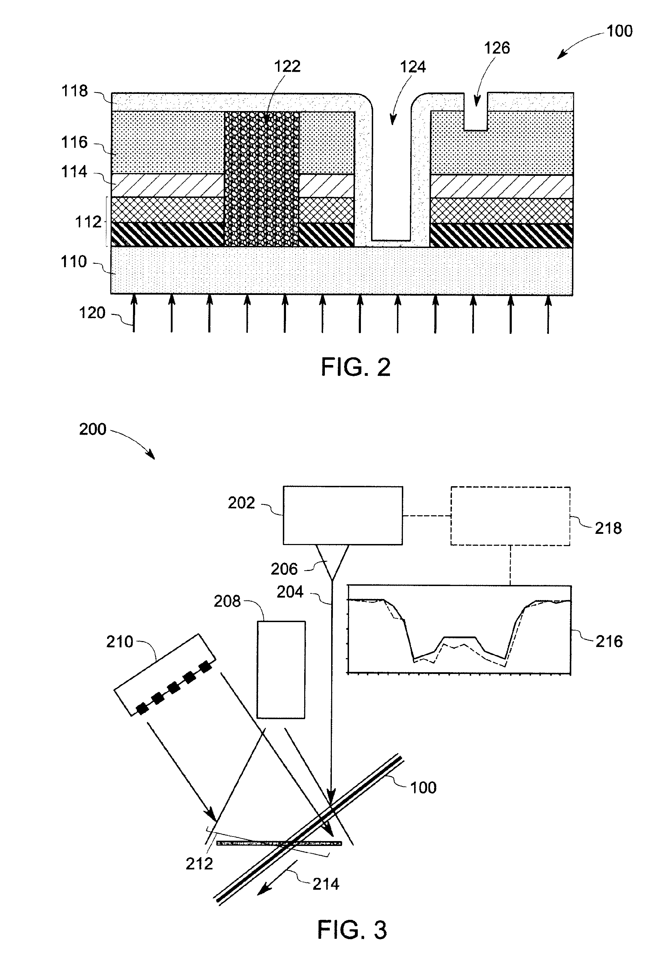

Typically, a photovoltaic device comprises a series of photovoltaic cells. In one embodiment, the photovoltaic cells includes a multilayer panel 100 comprising a substrate 110 with multiple layers. Fig. 2 is a schematic illustration of a photovoltaic cell having a multilayer panel 100. The panel 100 includes a layer, such as one or more layers 110, 112, 114, 116, and 118. In one embodiment, the multilayer panel 100 includes a substrate 110 and a transparent conductive layer 112 disposed over the substrate 110. In the illustrated embodiment, the multilayer panel may further include a transparent window layer 114 disposed over the transparent conductive layer 112, a first semiconducting layer 116 disposed over the transparent conductive layer 112, and a back contact layer 118 disposed over the first semiconducting layer.

The configuration of the layers illustrated in Fig. 2 may be referred to as a "superstrate" configuration since the light 120 enters from the substrate 110 and then passes on into the multilayer panel. Since, in this embodiment the substrate layer 110 is in contact with the transparent conductive layer 112, the substrate layer 110 is generally sufficiently transparent for visible light to pass through the substrate layer 110 and come in contact with the front contact layer 112. Suitable examples of materials used for the substrate layer 110 in the illustrated configuration include glass, composite, or a polymer. In one embodiment, the polymer comprises a transparent polycarbonate or a polyimide. Generally, the substrate may include substrates of any suitable material, including, but not limited to, metal, semiconductor, doped semiconductor, amorphous dielectrics, crystalline dielectrics, and combinations thereof.

The transparent conductive layer and the back contact layers, during operation, carry electric current out to an external load and back into the multilayer panel, thus completing an electric circuit. Suitable materials for transparent conductive layer 112 may include an oxide, sulfide, phosphide, telluride, or combinations thereof. These transparent conductive materials may be doped or undoped. In one embodiment, the transparent conductive layer 112 comprises a transparent conductive oxide, examples of which include zinc oxide, tin oxide, cadmium tin oxide (Cd₂Sn0₄), zinc tin oxide (ZnSnOₓ), indium tin oxide (ITO), aluminum-doped zinc oxide (ZnO:Al), zinc oxide (ZnO), and/or fluorine-doped tin oxide (SnO:F), titanium dioxide, silicon oxide, fluorine-doped tin oxide, gallium indium tin oxide(Ga-In-Sn-O), zinc indium tin oxide (Zn-In-Sn-O), gallium indium oxide (Ga-In-O), zinc indium oxide (Zn-In-O),and combinations of these. Suitable sulfides may include cadmium sulfide, indium sulfide and the like. Suitable phosphides may include indium phosphide, gallium phosphide, and the like.

Typically, when light falls on a photovoltaic cell that includes the multilayer panel 100, electrons in the first semiconducting layer (also sometimes referred to as "semiconductor absorber layer" or "absorber layer") 116 are excited from a lower energy "ground state", in which they are bound to specific atoms in the solid, to a higher "excited state," in which they can move through the solid. Since most of the energy in sunlight and artificial light is in the visible range of electromagnetic radiation, a semiconducting layer also known as the absorber layer should be efficient in absorbing radiation at those wavelengths. In one embodiment, the first semiconducting layer 116 comprises cadmium telluride, cadmium zinc telluride, cadmium sulfur telluride, cadmium manganese telluride, or cadmium magnesium telluride. Cadmium telluride (also sometimes referred to as "CdTe"), is a prominent polycrystalline thin-film material, with a bandgap of about 1.45 electron volts to about 1.5 electron volts and a high absorptivity. In one embodiment, the CdTe may be alloyed with zinc, magnesium, manganese, and a few other elements to vary its electronic and optical properties.

The cadmium telluride may, in certain embodiments, comprise other elements from the Group II and Group VI or Group III and Group V that may not result in large bandgap shifts. In one embodiment, the first semiconducting layer includes cadmium telluride, cadmium zinc telluride, tellurium-rich cadmium telluride, cadmium sulfur telluride, cadmium manganese telluride, or cadmium magnesium telluride. In one embodiment, the atomic percent of cadmium in the cadmium telluride is in the range from about 48 atomic percent to about 52 atomic percent. In another embodiment, the atomic percent of tellurium in the cadmium telluride is in the range from about 45 atomic percent to about 55 atomic percent. In one embodiment, the cadmium telluride employed may include a tellurium-rich cadmium telluride, such as a material wherein the atomic percent of tellurium in the tellurium-rich cadmium telluride is in the range from about 52 atomic percent to about 55 atomic percent. In one embodiment, the atomic percent of zinc or magnesium in cadmium telluride is less than about 10 atomic percent. In another embodiment, the atomic percent of zinc or magnesium in cadmium telluride is about 8 atomic percent. In yet another embodiment, the atomic percent of zinc or magnesium in cadmium telluride is about 6 atomic percent. In one embodiment, the CdTe layer may comprise p-type grains and n-type grain boundaries.

In the illustrated embodiment, the multilayer panel 100 further includes a transparent window layer 114. The transparent window layer 114, may be disposed on the first semiconducting layer 116. In one embodiment, the transparent window layer 114 may include cadmium sulfide, zinc telluride, zinc selenide, cadmium selenide, cadmium sulfur oxide, and or copper oxide. In another embodiment, the transparent window layer may further include oxygen. Typically, the first semiconducting layer 116 and the transparent window layer 114 thereby provide a heterojunction interface between the two layers. In some embodiments, the transparent window layer I I4 acts as an n-type window layer that forms the pn-junction with the p-type first semiconducting layer.

As illustrated in Fig.2, the multilayer panel includes a back contact layer 118, which transfers current in or out of multilayer panel 100, depending on the overall system configuration. Generally, back contact layer 118 comprises a metal, a semiconductor, graphite, other appropriately electrically conductive material, or combinations thereof. In one embodiment, the back contact layer 118 comprises a semiconductor comprising p-type grains and p-type grain boundaries. The p-type grain boundaries will assist in transporting the charge carriers between the back contact metal and the p-type semi-conductor layer. In some embodiments, the back contact layer may comprise one or more of a semiconductor selected from zinc telluride (ZnTe), mercury telluride (HgTe), cadmium mercury telluride (CdHgTe), arsenic telluride (As₂Te₃), antimony telluride (Sb₂Te₃), and copper telluride (CuₓTe).

In some embodiments a metal layer (not shown) may be disposed on the back contact layer 118 for improving the electrical contact. In some embodiment, the metal layer includes one or more of group IB metal, or a group IIIA metal, or a combination thereof. Suitable non-limiting examples of group IB metals include copper (Cu), silver (Ag), and gold (Au). Suitable non-limiting examples of group IIIA metals (e.g., the low melting metals) include indium (In), gallium (Ga), and aluminum (Al). Other examples of potentially suitable metals include molybdenum and nickel.

In one embodiment, the multilayer panel 100 may further include a second semiconducting layer (not shown) disposed on the first semiconducting layer 116. In one embodiment, the second semiconducting layer includes n-type semiconductor. The second semiconducting layer may include an absorber layer which is the part of the multilayer panel 100 where the conversion of electromagnetic energy of incident light (for instance, sunlight) to electrical energy (that is, to electrical current), occurs. The second semiconducting layer may be selected from bandgap engineered II-VI compound semiconductors, for example, cadmium zinc telluride, cadmium sulfur telluride, cadmium manganese telluride, cadmium mercury telluride, cadmium selenide, or cadmium magnesium telluride. In one embodiment, the second semiconducting layer may include a copper indium gallium diselenide (CIGS).

Generally, a first semiconducting layer 116 may be disposed on the transparent conductive layer 112 and a second semiconducting layer may be disposed on the first semiconducting layer 116. The first semiconducting layer 116 and the second semiconducting layer may be doped with a p-type doping or n-type doping such as to form a heterojunction. As used herein, the term "heterojunction" is a semiconductor junction which is composed of layers of dissimilar semiconductor material. These materials usually have non-equal band gaps. As an example, a heterojunction can be formed by contact between a layer or region of one conductivity type with a layer or region of opposite conductivity, e.g., a "p-n" junction. In addition to solar cells, other devices, which utilize a multilayer panel 100 having a heterojunction, include thin film transistors and bipolar transistors.

In some other embodiments, the multilayer panel 100 may further include a high resistance transparent layer (not shown). The high resistant transparent layer may be disposed between the transparent conductive layer 112 and the transparent window layer 114. The high resistant transparent layer may be selected from tin oxide, zinc oxide, zinc tin oxide (Zn-Sn-O), or zinc indium tin oxide (Zn-In-Sn-O). In one embodiment, the device does not include a high resistance transparent layer.

In an alternative embodiment, a "substrate" configuration comprises a photovoltaic device wherein a back contact layer 118 is disposed on a substrate layer 110. Further a first semiconducting layer 116 is disposed over the back contact layer 118. A transparent window layer 114 is then disposed on the first semiconducting layer 116 and a transparent conductive layer 112 is disposed on the transparent window layer 114. In the substrate configuration, the substrate layer may comprise glass, polymer, or a metal foil. In one embodiment, metals that may be employed to form the metal foil include stainless steel, molybdenum, titanium, and aluminum. In one embodiment, the first semiconducting layer 116 may be selected from copper indium disulfide (CIS), copper indium diselenide (CIS), copper indium gallium diselenide (CIGS), copper indium gallium sulfur selenium (CIGSS), copper indium gallium aluminum sulfur selenium (Cu(In,Ga,Al)(S,Se)₂), copper zinc tin sulfide (CZTS) and other CIS-based systems.

In one embodiment, the multilayer panel 100 comprises a transparent conductive layer 112 and a first semiconducting layer 116 each having a thickness in a range of about a 50 nanometers to about 200 microns. The scribed multilayer panel (also referred to herein simply as a scribed panel) as shown in Fig. 2 includes grooves or scribed lines 120, 122 and 124. The scribing of the multilayer panel 100 may be carried out using a number of techniques known to one skilled in the art for example etching, mechanical scribing, electrical discharge scribing, laser scribing and the like. Typically, the scribed lines function as an isolating scribed line (120, 124) or a conduction connection scribed line (122). In one embodiment, at least one cell isolation scribe line is formed on the multilayer panel 100. Additionally, a second electrical contact layer isolation scribe line (not shown) may be formed on the multilayer panel. Typically, the cell isolation scribe lines delineate the multilayer panel 100 comprising the transparent conductive layer and the first semiconducting layer into a plurality of cells. For example in one embodiment, the first semiconducting layer is separated by the first scribed line. The conduction connection scribed line may be patterned between each of the cell isolation scribe lines.

In one embodiment, the thickness of the scribed lines may vary. In one embodiment, the scribed lines may have a width in a range from about 10 micrometers to about 150 micrometers.

The scribed lines may be spaced on the multilayer panel 100 at various distances. In one embodiment, the scribed lines are spaced apart at a distance in a range from about 1 millimeter to about 30 millimeters. In yet another embodiment, the scribed lines may be spaced apart from one another at a distance in a range from about 5 millimeters to about 20 millimeters. The spacing of the scribed lines may be used to determine the width of individual cells in a scribed multilayer panel, for example a scribed multilayer panel useful as a photovoltaic device. In one embodiment, the scribed lines may be parallel to each other. In another embodiment, the scribed lines may be parallel to the edge of the substrate 110. Generally, for efficiency and reliability of the photovoltaic device, the uniformity and depth of the scribed lines is an essential factor.

Although aspects of the invention are described in detail in terms of the laser scribing of a multilayer panel 100, the inventive concepts disclosed herein may be used in conjunction with any number of a variety of scribing techniques. As mentioned earlier herein, real time optical monitoring of the characteristics (e.g. line depth and or line width) of a line being inscribed in a multilayer panel 100 using techniques disclosed herein may be carried out using techniques known to those of ordinary skill in the art, for example chemical etching, mechanical scribing, electrical discharge scribing, laser scribing and the like. Thus, in one embodiment the present invention provides a method of scribing a multilayer panel, the method comprising: (a) providing a multilayer panel comprising a substrate layer, a transparent conductive layer disposed thereupon, a first semiconducting layer disposed upon the transparent conductive layer; (b) configuring the multilayer panel relative to a machining device, the machining device comprising a machining tool and an optical sensor; (c) inducing a motion of the machining tool relative to the multilayer panel such that the machining tool traverses at least a portion of the multilayer panel, the machining tool being characterized by an ablative action upon the panel of sufficient energy to ablate one or more layers of the multilayer panel within a zone affected by the machining tool to provide a scribed panel;(d) simultaneous with step (c) irradiating at least a portion of the scribed panel with light from a first light source; and (e) detecting the light emerging from the scribed panel at the optical sensor in real time. As noted, in one embodiment the machining tool is a laser head.

In one embodiment of the present invention, the method of scribing the multilayer panel 100 includes a laser scribing technique. The method includes configuring the multilayer panel 100 relative to a laser machining device. Referring to Fig. 3 which is a schematic representation of a system 200 for scribing a multilayer panel 100, the system 200 includes a laser machining device comprising a laser source 202 for generating a laser beam 204. In one embodiment, the laser may be a gas, liquid or a solid laser. Non-limiting examples of gas lasers include He--Ne, He--Cd, Cu vapor, Ag vapor, HeAg, NeCu, CO₂, N₂, HF-DF, far infrared, F₂, XeF, XeCl, ArF, KrCI, and KrF lasers. Examples of liquid lasers include but are not limited to dye lasers; and non-limiting examples of solid lasers include ruby, Nd:YAG, Nd:glass, color center, alexandrite, Ti:sapphire, Yb:KGW, Yb:KYW, Yb:SYS, Yb:BOYS, Yb:CaF₂, semiconductor, glass and optical fiber hosted lasers, vertical cavity surface-emitting laser (VCSEL), and laser diode lasers. In another embodiment, the laser source 202 may be an x-ray, infrared, ultraviolet, or free electron transfer laser. In some embodiments, the laser beam 204 is generated by a pulsed laser. In another embodiments, a laser beam 204 irradiates continuous energy. In one embodiment, the laser beam 204 has a wavelength in a range from about 250 nanometers to about 1550 nanometers. In one embodiment, the laser beam 204 is a pulsed laser beam having a frequency in a range from about 1 kilohertz to about 80 megahertz. In another embodiment, the pulsed laser beam 204 has a pulse duration in a range from about 1 femtosecond to about 600 nanoseconds. In yet another embodiment, the laser beam 204 may have a Gaussian shape. In another embodiment, the laser beam 204 may have a top-hat shape. In some embodiments, the laser beam 204 comprises more than one laser beam component. The laser beam 204 has sufficient energy to ablate one or more layers of the multilayer panel 100 within a zone irradiated to provide a scribed panel. In one embodiment, the intensity of the laser beam 204 incident on the multilayer panel 100 is in a range from one to ten times of the damage threshold of at least one of the layers of the multilayer panel 100. In one embodiment, the laser beam 204 ablates the multilayer panel 100 at a speed in a range from about 50 mm/s to about 10 m/s.

The laser machining device 200 includes a laser head 206. Typically, a motion of the laser head 206 is induced relative to the multilayer panel 100 such that the laser beam 204 contacts the multilayer panel 100 along a transverse line across the panel and travels at a speed relative to the surface of the multilayer panel 100 in a range from about 50 millimeters per second (mm/s) to about 10 m/s. As noted, the laser beam 204 has sufficient energy to ablate one or more layers of the multilayer panel 100 within the zone irradiated by the laser to form the grooves or scribed lines. In one embodiment as illustrated in Fig. 3 the multilayer panel 100 moves in a direction shown by the arrow 214 with respect to the laser head 206. In another embodiment, the multilayer panel 100 is stationary while the laser head 206 traverses a line across the multilayer panel 100. In some embodiments, the laser beam 204 and the multilayer panel 100 move with a periodic motion with respect to each other. In some other embodiments, the laser beam 204 or multilayer panel 100 move in a non-periodic motion in one or more dimensions with respect to each other.

Referring to Fig. 3 the system includes a first light source 210. In one embodiment, the first light source 210 is disposed such that the first light source 210 irradiates a zone 212 of the scribed panel simultaneously as the laser beam ablates one or more layers of the multilayer panel 100 within the same zone 212. In one embodiment, the first light source 210 may be selected from the group consisting of a light emitting diode (LED) array, a fiber optic light, an incandescent light, a laser source, and combinations thereof. In one embodiment, the first light source 210 may be a uniform diffuse light source such as a diffuse light box employing an LED (light emitting diode) located behind a diffuser panel including a material such as plastic or glass. In another embodiment, the first light source 210 may be a directional light source such as an LED mounted with a lens to collect and collimate the light. In one embodiment, the first light source 210 is a light emitting diode. Typically, the light from the first light source 210 simultaneously irradiates a zone 212 of the scribed panel as the scribing of the multilayer panel 100 is in process, which is then reflected. In one embodiment, the first light source 210 traverses the path of the laser head 206 simultaneously with the passage of the laser head 206. In one embodiment, the first light source 210 may be mounted on the same movable component of the laser machining device as the laser head 206 in a position after the laser head 206 relative to the scribing direction. In another embodiment, the first light source 210 may be stationary. In yet another embodiment, the first light source 210 may be located at a plurality of locations thereby irradiating more than one zone of the multilayer panel 100.

The laser machining device includes an optical sensor 208. The optical sensor 208 is configured to receive light emerging from the scribed panel in real time, meaning that the optical sensor 208 is configured to receive light emerging from the multilayer panel 100 being scribed simultaneously with the scribing process. A wide variety of suitable optical sensors are known to those of ordinary skill in the art. In one embodiment, the optical sensor 208 is selected from the group consisting of a photodiode array, a complementary metal-oxide semiconductor (CMOS) array, a lateral effect photodiode, a line scan camera, and combinations thereof. In another embodiment, the optical sensor 208 is may include a two dimension video camera. In another embodiment, the optical sensor 208 may be configured to follow the laser beam 204. In one embodiment, the system may include a plurality of optical sensors.

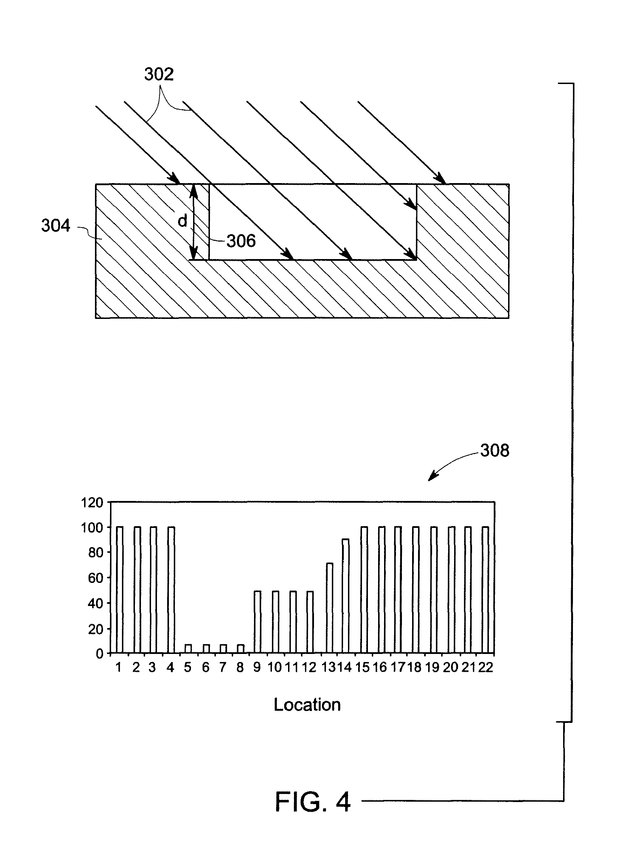

As illustrated in Fig.3 the optical sensor 208 is further coupled to an inferential sensor 216. In one embodiment, the inferential sensor 216 and the optical sensor 208 may be present in the same location as illustrated in Fig.2. In another embodiment, the inferential sensor 216 and the optical sensor 208 may be present at a distance apart from each other. Using the intensity of the light emerging from the scribed panel, in real time, the inferential sensor 216 is capable of estimating the thickness of the layers in the scribed panel based on the intensity profile of the reflected light emerging from the scribed panel. As illustrated in Fig. 4 when the incident light 302 from the first light source 210 (not shown) irradiates the scribed panel 304, depending on the depth 306 of the scribed lines in the scribed panel 304, the intensity of the light emerging out of the scribed panel 306 would vary, thereby generating an intensity profile 308 for the scribed panel 304. In one embodiment, a tilted directional light at an angle alpha may be employed to simultaneously irradiate the scribed panel as the scribing process is in progress. In one embodiment, the intensity profile 308 thus generated in real time is compared to a reference intensity profile of a reference set of scribed lines. In one embodiment, the difference in the intensity profiles of the reference scribed lines and that of the lines scribed in real time is then used to determine the quality of the lines scribed in real time. In one embodiment, if the intensity profile 308 is off set from the intensity profile of the reference by greater than a preset standard, such as about 10%, then the scribing parameters may be varied to obtain scribed lines of the required quality.

In one embodiment as illustrated in Fig. 2, the system 200 further comprises a control unit 218. The control unit 218 may utilize the difference in the intensity profiles of the reference and the real time scribed lines obtained from the inferential sensor 216, to modulate at least one of the laser processing conditions for example laser focus, scanning speed, laser power etc, in the laser machining device to control the scribing of the multilayer panel 100 using a control algorithm.

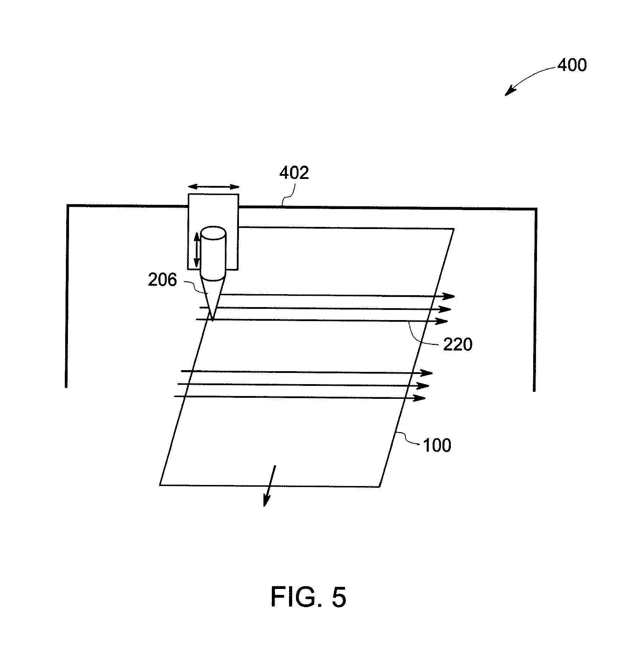

In one embodiment, the motion of the laser machining device may be a scanner motion wherein the multilayer panel 100 is stationary while the laser machining device 100 moves the laser beam at a high speed. In another embodiment, the motion of the laser machining device may be motion based such as a gantry 402 system. In one embodiment, as illustrated in Fig 5 the system 400 for scribing a multilayer panel 100 may be mounted on a gantry 402. As shown in Fig. 5 the laser machining device may move in a traverse direction while the laser beam 204 may be adjusted with the vertical direction. In one embodiment, the laser head 206 may be stationary with respect to the multilayer panel 100. In another embodiment, the laser head 206 may traverse across the multilayer panel 100 in a perpendicular direction with respect to the motion of the multilayer panel 100 as shown by the arrow 214. Typically, the motion of the multilayer panel 100 is relatively slower than the motion of the laser head 206.

In another embodiment, the present invention provides a system for scribing a multilayer panel 100. The system includes a laser machining device; a first light source 210; and an inferential sensor 216. The laser machining device comprising a laser source 202, a laser head 206 and an optical sensor 208. The optical sensor 208 is configured to receive light emerging from a multilayer panel 100.

This written description uses examples to disclose the invention, including the preferred mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

Various aspects and embodiments of the present invention are defined by the following numbered clauses:
1. A method of scribing a multilayer panel, the method comprising:
   (a) providing a multilayer panel comprising a substrate layer, a transparent conductive layer disposed thereupon, a first semiconducting layer disposed upon the transparent conductive layer;
   (b) configuring the multilayer panel relative to a laser machining device, the machining device comprising a laser source, a laser head and an optical sensor;
   (c) inducing a motion of the laser head relative to the multilayer panel such that a laser beam contacts the panel along a transverse line across the panel, the laser beam incident upon the panel having sufficient energy to ablate one or more layers of the multilayer panel within a zone irradiated by the laser beam to provide a scribed panel;
   (d) simultaneously irradiating at least a portion of the scribed panel with light from a first light source; and
   (e) detecting the light emerging from the scribed panel at the optical sensor in real time.
2. The method according to clause 1, wherein the substrate is a transparent substrate comprising a glass or a polymer
3. The method according to any preceding clause, wherein the transparent conductive layer comprises a transparent conductive oxide.
4. The method according to any preceding clause, wherein the transparent conductive oxide is selected from the group consisting of cadmium tin oxide, zinc tin oxide, indium tin oxide, aluminum-doped zinc oxide, zinc oxide, fluorine doped tin oxide, and combinations thereof.
5. The method according to any preceding clause, wherein the first semiconducting layer is selected from the group consisting of cadmium telluride, cadmium zinc telluride, tellurium-rich cadmium telluride, vanadium sulfur telluride, cadmium manganese telluride, cadmium magnesium telluride and combinations thereof.
6. The method according to any preceding clause, wherein the multilayer panel further comprises a second semiconducting layer.
7. The method according to any preceding clause, wherein the second semiconducting layer selected from the group consisting of cadmium zinc telluride, cadmium sulfur telluride, cadmium manganese telluride, cadmium mercury telluride, cadmium selenide, cadmium magnesium telluride, copper indium gallium diselenide and combinations thereof.
8. The method according to any preceding clause, wherein the optical sensor is selected from the group consisting of a photodiode array, a complementary metal-oxide semiconductor array, a lateral effect photodiode, a line scan camera and combinations thereof.
9. The method according to any preceding clause, wherein the laser beam incident upon the panel is characterized by a intensity level in a range from about one to 10 times of the damage threshold of the material.
10. The method according to any preceding clause, wherein the laser beam incident upon the panel is characterized by a pulse in a range from about 1 femtosecond nanoseconds to about 600 nanoseconds.
11. The method according to any preceding clause, wherein the motion of the laser head is perpendicular relative to the multilayer panel.
12. The method according to any preceding clause, wherein the motion of the laser head relative to a surface of the multilayer panel is characterized by a speed of about 50 mm/s to 10 m/s.
13. The method according to any preceding clause, wherein the laser source is a pulsed laser.
14. The method according to any preceding clause, wherein first light source is at least one selected from a laser diode, an LED, a fiber optic light and combinations thereof.
15. The method according to any preceding clause, wherein the first light source moves relative to the multilayer panel.
16. The method according to any preceding clause, wherein the first light source is stationary.
17. The method according to any preceding clause, wherein the first light source may comprise a plurality of light sources.
18. A system for scribing a multilayer panel comprising:
   a laser machining device comprising a laser source, a laser head and an optical sensor and a means for inducing a motion of the laser head relative to a multilayer panel;
   a first light source;
   wherein the optical sensor is configured to receive light emerging from a multilayer panel; and
   an inferential sensor.
19. The system of any preceding clause, wherein the multilayer panel is a photovoltaic device.
20. The system of any preceding clause, wherein the first light may comprise a plurality of light sources.
21. The system of any preceding clause, wherein the system further comprises a control unit.

## Claims

1. A method (10) of scribing a multilayer panel, the method comprising:
(a) providing (12) a multilayer panel (100) comprising a substrate layer (110), a transparent conductive layer (112) disposed thereupon, a first semiconducting layer (116) disposed upon the transparent conductive layer;
(b) configuring (14) the multilayer panel (100) relative to a laser machining device, the machining device comprising a laser source, a laser head and an optical sensor;
(c) inducing (16) a motion of the laser head relative to the multilayer panel such that a laser beam contacts the panel along a transverse line across the panel, the laser beam incident upon the panel having sufficient energy to ablate one or more layers of the multilayer panel within a zone irradiated by the laser beam to provide a scribed panel;
(d) simultaneously (24) irradiating at least a portion of the scribed panel with light from a first light source; and
(e) detecting (26) the light emerging from the scribed panel at the optical sensor in real time.

2. The method (10) according to claim 1, wherein the transparent conductive layer (112) comprises a transparent conductive oxide.

3. The method (10) according to claim 2, wherein the transparent conductive oxide is selected from the group consisting of cadmium tin oxide, zinc tin oxide, indium tin oxide, aluminum-doped zinc oxide, zinc oxide, fluorine doped tin oxide, and combinations thereof.

4. The method (10) according to any of claims 1 to 3, wherein the first semiconducting layer (116) is selected from the group consisting of cadmium telluride, cadmium zinc telluride, tellurium-rich cadmium telluride, vanadium sulfur telluride, cadmium manganese telluride, cadmium magnesium telluride and combinations thereof.

5. The method (10) according to any preceding claim, wherein the multilayer panel further comprises a second semiconducting layer.

6. The method (10) according to claim 5, wherein the second semiconducting layer selected from the group consisting of cadmium zinc telluride, cadmium sulfur telluride, cadmium manganese telluride, cadmium mercury telluride, cadmium selenide, cadmium magnesium telluride, copper indium gallium diselenide and combinations thereof.

7. The method according to any preceding claim, wherein the laser beam incident upon the panel (100) is **characterized by** an intensity level in a range from about one to 10 times of the damage threshold of the material.

8. A system (200) for scribing a multilayer panel (100) comprising:
a laser machining device comprising a laser source (202), a laser head (206), an optical sensor (208) and a means for inducing a motion of the laser head (206) relative to a multilayer panel;
a first light source (210);
wherein the optical sensor (208) is configured to receive light emerging from a multilayer panel (100); and
an inferential sensor (216).

9. The system (200) of claim 8, wherein the multilayer panel (100) is a photovoltaic device.

10. The system (200) of claim 8 or claim 9, wherein the first light source (210) comprises a plurality of light sources.
